# FASCICULE DE BREVET EUROPEEN

(11) **EP 3 160 215 B1**
(45) Date de publication et mention de la délivrance du brevet: **13.06.2018**
(21) Numéro de dépôt: 16193702.4
(22) Date de dépôt: 13.10.2016
(51) Int. Cl.: H05K 1/02, B60Q 1/00

(54) **CARTE DE CIRCUIT IMPRIMÉ FLEXIBLE, ET MODULE LUMINEUX POUR VÉHICULE AUTOMOBILE COMPORTANT UNE TELLE CARTE DE CIRCUIT IMPRIMÉ**
GEDRUCKTE FLEXIBLE SCHALTKREISKARTE UND LICHTMODUL FÜR KRAFTFAHRZEUG, DAS EINE SOLCHE FLEXIBLE GEDRUCKTE SCHALTKREISKARTE UMFASST
FLEXIBLE PRINTED CIRCUIT BOARD, AND LUMINOUS MODULE FOR MOTOR VEHICLE COMPRISING SUCH A PRINTED CIRCUIT BOARD

(30) Priorité: 21.10.2015 FR 1560046
(43) Date de publication de la demande: 26.04.2017
(73) Titulaire: VALEO VISION, 93012 Bobigny Cedex (FR)
(72) Inventeur: BADIA, Olivier, 94350 Villiers sur Marne (FR)

(56) Documents cités:
- EP-A1- 2 298 599
- DE-A1- 4 237 083
- US-A1- 2015 257 289

## Description

### Domaine technique de l'invention

L'invention a pour objet une carte de circuit imprimé flexible.

Elle trouve son application plus particulièrement dans le cadre du montage de la carte de circuit imprimé flexible dans un module lumineux dynamique et/ou flexible, en particulier de projecteur d'éclairage pour véhicule automobile.

### Arrière-plan technique de l'invention

Les cartes de circuit imprimé sont couramment utilisées pour assurer le montage et l'interconnexion de composants électroniques. Elles sont composées en général d'un substrat en plastique et métal rigide, sur lequel sont déposées des pistes conductrices de connexion électrique sur lesquelles sont soudées des composants électroniques.

Il est connu d'utiliser des cartes de circuit imprimé flexibles, lorsque l'application l'impose, qui sont en général réalisées à l'aide de substrats en plastiques souples hautes performances, tels que des polyimides. Par exemple, le document EP2298599A1 divulgue un module optique équipé d'un organe de raccordement électrique comprenant un élément flexible intégrant des conducteurs électriques. Le document DE4237083 divulgue une carte de circuit imprimé, comprenant un élément flexible étant configuré pour être courbé sur un élément de renforcement. Toutefois, dans certaines applications où il y a peu d'espace disponible et où l'environnement mécanique se trouve être très contraignant, le rayon de courbure imposé au circuit imprimé flexible peut être très petit et risquer, surtout dans un cadre dynamique, c'est-à-dire lorsque la carte de circuit imprimé relie deux composants électroniques en mouvement l'un par rapport à l'autre, d'endommager la carte de circuit imprimé et ses pistes conductrices.

### Résumé de l'invention

L'invention a pour but de résoudre cette difficulté en procurant une solution simple, peu encombrante, nécessitant un minimum de pièces supplémentaires, peu onéreuse, tout en permettant une fiabilité satisfaisante et un assemblage aisé et donc rapide des différents éléments du dispositif dans lequel elle est montée.

A cet effet, l'invention a pour objet une carte de circuit imprimé flexible, configurée pour recevoir des composants électroniques, comportant un élément flexible, électriquement isolant, configuré pour porter des pistes conductrices de connexion des composants, l'élément flexible étant en outre configuré pour être courbé selon une courbure,
la carte comportant en outre au moins un élément de renforcement, électriquement isolant, solidaire mécaniquement de l'élément flexible, s'étendant d'un côté de la courbure, et comportant deux parties :
- une première partie étant sensiblement plane,
- une deuxième partie présentant une courbure prédéfinie, disposée du côté de la courbure de l'élément flexible,
l'élément de renforcement étant disposé de sorte à laisser une partie libre pour l'élément flexible pour être courbée selon ladite courbure.

De cette façon, les éléments de renforcement accompagnent la courbure de l'élément flexible sur leur deuxième partie, tout en permettant de la limiter, et permettent de gérer précisément la courbure restante, le rayon de courbure et la longueur disponible de l'élément flexible étant alors déterminés, évitant ainsi des rayons de courbure trop petits, susceptibles d'endommager l'élément flexible et améliorant ainsi la fiabilité de l'ensemble.

Selon différents modes de réalisation de l'invention, qui pourront être pris ensemble ou séparément :
- la carte de circuit imprimé comporte en outre au moins un élément raidisseur, disposé du même côté de sa partie libre que l'élément de renforcement et fixé sur l'élément flexible ou sur l'élément de renforcement;
- l'élément de renforcement est disposé sur la face interne de l'élément flexible;
- l'élément de renforcement est disposé sur la face externe de l'élément flexible;
- la carte de circuit imprimé comporte un deuxième élément de renforcement, chacun des élément de renforcement s'étendant de part et d'autre de la courbure et les éléments de renforcement étant disposés de sorte à laisser entre eux la partie libre pour l'élément flexible pour être courbée selon ladite courbure;
- la carte de circuit imprimé comporte au moins deux éléments raidisseurs, disposés de part et d'autre de sa partie libre et fixés chacun sur l'élément flexible ou respectivement sur un des élément de renforcement;
- la carte de circuit imprimé comporte quatre éléments de renforcement, disposés en vis-à-vis de part et d'autre de l'élément flexible ;
- l'élément flexible comporte du polyimide ;
- l'élément flexible a une épaisseur d'environ 110 micromètres ;
- les éléments de renforcement comportent du polyamide ;
- les éléments de renforcement ont une épaisseur d'environ 100 à 600 micromètres.

L'invention se rapporte également à un module lumineux pour dispositif d'éclairage et/ou de signalisation, notamment pour véhicule automobile, comportant une carte de circuit imprimé selon l'invention, les éléments raidisseurs étant en outre fixés à un composant du module.

Selon un autre mode de l'invention, l'un des éléments raidisseurs est fixé à un composant fixe du module et l'autre des éléments raidisseurs, à un composant mobile du module. Il est aussi possible que l'un des éléments raidisseurs soit fixé à un premier composant du module et l'autre des éléments raidisseurs fixé à un deuxième composant du module, les deux composants du module étant prévus pour être en mouvement l'un par rapport à l'autre.

Dans ce dernier mode, où on se trouve dans un environnement mécanique mobile, ou dynamique, l'invention permet d'accompagner les mouvements de la courbure liés au mouvement du ou des composant(s) du module et d'éviter ainsi toute géométrie de la carte susceptible de l'endommager.

### Bref descriptif des figures

D'autres caractéristiques et avantages de l'invention ressortiront de la description détaillée qui suit, donnée à titre indicatif et illustrée par les dessins annexés, qui représentent :
- la figure 1, une vue schématique de dessus d'un mode de réalisation de la carte de circuit imprimé flexible selon l'invention ;
- la figure 2, une vue schématique en perspective de la carte de circuit imprimé de la figure 1.

Sur ces différentes figures, les mêmes références se rapportent aux mêmes éléments.

### Description détaillée de l'invention

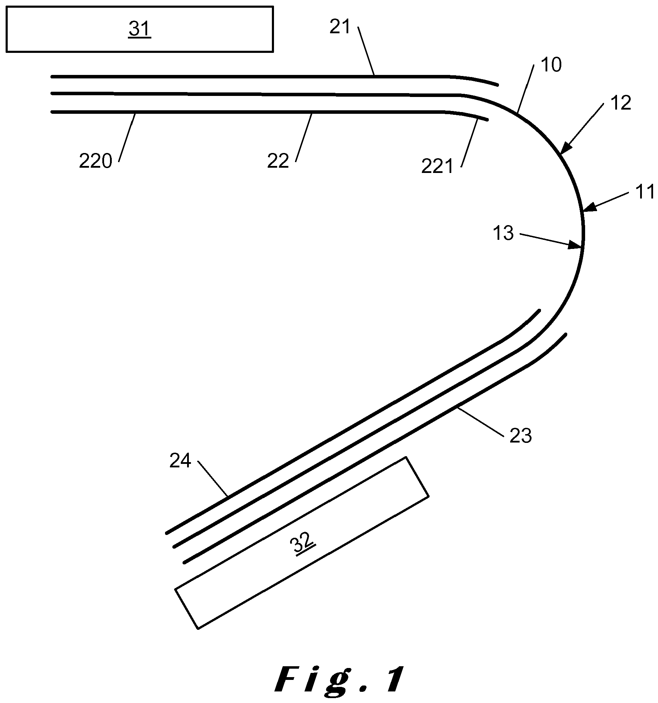

La figure 1 représente un mode de réalisation de la carte de circuit imprimé selon l'invention, vu schématiquement de dessus.

La carte comporte des composants électroniques (non-représentés) et un élément flexible 10, électriquement isolant, et portant des pistes conductrices (également non représentées) sur une ou deux de ses faces, destinées à interconnecter les composants entre eux et avec des circuits électriques extérieurs à la carte.

L'élément flexible 10 comporte par exemple un substrat plastique hautes performances, tels qu'un polyimide. Son épaisseur peut être classiquement d'environ 110 micromètres. Sur la figure, une partie de l'élément flexible est représentée, de part et d'autre d'une grande courbure (supérieure à 90°) en sa partie centrale 11.

La carte de circuit imprimé selon l'invention comporte préférentiellement au moins deux éléments de renforcement 22 et 24. Ils sont disposés de part et d'autre de la partie centrale 11 de l'élément flexible 10, par exemple sur la même face de celui-ci, par exemple sur la face interne 13 par rapport à la courbure, en laissant libre la partie centrale 11 de l'élément flexible. Il est aussi possible que les deux éléments de renforcements 22 et 24 soient placés sur la face externe 12 par rapport à la courbure ou sur des faces opposées.

Sur la figure 1, le dispositif comporte quatre éléments de renforcement, les deux éléments supplémentaires 21 et 23 étant disposés sur l'autre face de l'élément flexible, face externe repérée 12, en vis-vis des éléments 22 et 24 respectivement.

Chacun de ces éléments de renforcement 21-24 est électriquement isolant et rendu solidaire mécaniquement de l'élément flexible 10, par exemple par collage. Ils sont destinés à renforcer la résistance mécanique de l'élément flexible 10 au voisinage de la courbure 11. Ils sont par exemple en polyamide, par exemple d'une épaisseur d'environ 100 à 600 micromètres.

Chacun des éléments de renforcement 21-24 comporte au moins deux parties, la première, repérée 220, étant sensiblement plane et la seconde, repérée 221, présentant un rayon de courbure prédéfini, plus grand que celui de la partie centrale. La fonction de cette partie courbe 221 est d'amorcer la courbure, en évitant toute pliure nette à la sortie des éléments de renforcement, susceptible d'endommager l'élément flexible 10 et les pistes conductrices qu'il porte. Il est à noter que ce rayon de courbure peut n'être pas constant et diminuer en s'éloignant de la première partie. A cette fin, typiquement, le rayon de courbure de la deuxième partie ne doit pas être inférieur à 5 mm.

Enfin, la carte de circuit imprimé selon l'invention comporte en outre au moins deux éléments raidisseurs 31 et 32, situés respectivement de part et d'autre de la courbure 11 de l'élément flexible 10. Ces éléments raidisseurs ont par exemple au moins une surface sensiblement plane et sont par exemple constitués chacun par une pièce métallique rigide, en aluminium par exemple.

Les éléments raidisseurs 31 et 32 sont fixés d'une part à la carte de circuit imprimé par leur surface plane, par exemple du côté de la face externe 12. Ils sont fixés soit directement à l'élément flexible 10 si la carte ne comporte pas les éléments de renforcement 21 et 23, soit aux éléments de renforcement 21 et 23 s'ils existent. Les éléments raidisseurs 31 et 32 sont fixés d'autre part à l'environnement mécanique du circuit porté par la carte selon l'invention, par exemple à un composant, par exemple le boitier, d'un module lumineux pour véhicule automobile, et, ce, par tout moyen connu, tel que pions bouterollés ou sertis, clippage, rivetage ou adhésifs. L'un des éléments raidisseurs, 32, est par exemple fixé sur une partie mobile de l'environnement mécanique, alors que l'autre (31) est par exemple fixé sur une partie fixe de cet environnement. Cette configuration peut être par exemple celle d'un projecteur tournant pour l'éclairage avant d'un véhicule automobile.

Il apparaît, tout particulièrement dans le cas décrit ci-dessus où une partie de la carte de circuit imprimé est mobile, entrainée par l'élément raidisseur 32, que les éléments de renforcement 21-24 évitent toute déformation trop importante et tout rayon de courbure trop petit, susceptibles d'endommager la carte, au niveau de la zone où sont fixés les éléments raidisseurs lors des mouvements de l'environnement ; de plus, par leur seconde partie légèrement courbée, ils évitent que de telles déformations se produisent à la sortie des éléments de renforcement, comme indiqué plus haut, améliorant ainsi la fiabilité du montage électronique correspondant.

Ce résultat est obtenu avec peu de pièces supplémentaires, donc de façon peu onéreuse, la carte résultante n'ayant en outre pas un encombrement sensiblement augmenté, ce qui est important dans un environnement mécanique restreint.

L'épaisseur des éléments de renforcement 21-24, comme leur longueur et la longueur de la partie centrale libre de l'élément flexible peuvent bien entendu être choisis en fonction de l'environnement mécanique de la carte et de ses contraintes.

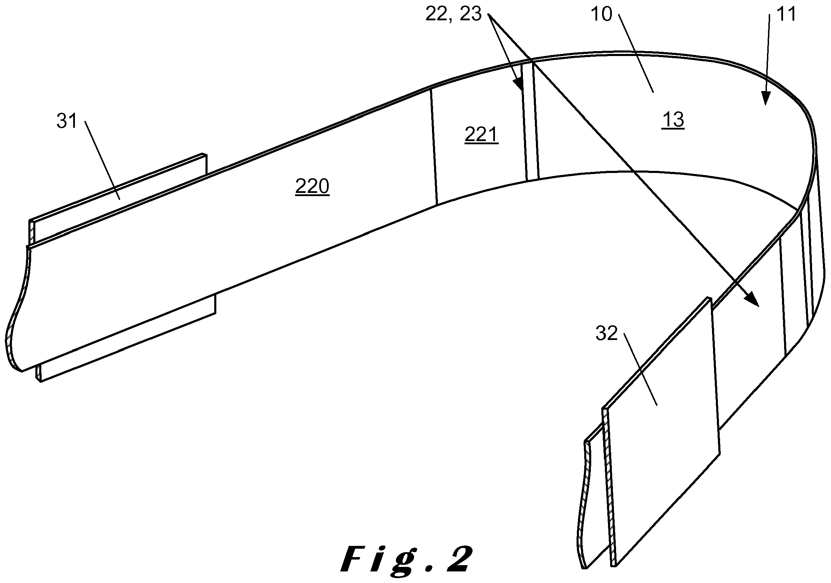

La figure 2 est une vue schématique en perspective de la carte de circuit imprimé représentée figure 1.

Sur cette figure, on retrouve l'élément flexible 10 courbé en sa partie 11. Sont visibles également sur cette figure les éléments de renforcement 22 (interne) et 23 (externe), dont on distingue les premières parties 220 et deuxièmes parties 221. Sur la figure 2, certains traits représentent la courbure de la carte de circuit imprimé.

Les éléments raidisseurs 31 et 32 sont schématisés par de simples plaques.

Dans une réalisation de l'invention non-représentée, la carte de circuit imprimé selon l'invention comporte un seul élément de renforcement 22. La carte de circuit imprimé comporte alors préférentiellement un seul élément raidisseur 31 situé du même côté de la courbure 11 de l'élément flexible 10 que l'élément de renfoncement 22.

## Revendications

1. Carte de circuit imprimé flexible, configurée pour recevoir des composants électroniques, comportant un élément flexible (10), électriquement isolant, configuré pour porter des pistes conductrices de connexion des composants, l'élément flexible étant en outre configuré pour être courbé selon une courbure (11),
la carte comportant en outre au moins un élément de renforcement (21,22,23,24), électriquement isolant, solidaire mécaniquement de l'élément flexible (10), s'étendant d'un côté de la courbure, et comportant deux parties :
- une première partie (220) étant sensiblement plane,
- une deuxième partie (221) présentant une courbure prédéfinie, disposée du côté de la courbure (11) de l'élément flexible (10), **caractérisée par** l'au moins un élément de renforcement (21,22,23,24) étant disposé de sorte à laisser une partie libre (11) pour l'élément flexible (10) pour être courbée selon ladite courbure.

2. Carte de circuit imprimé selon la revendication 1, **caractérisée par le fait qu'**elle comporte en outre au moins un élément raidisseur (31), disposé du même côté de sa partie libre que l'au moins un élément de renforcement (21,22,23,24) et fixé sur l'élément flexible (10) ou sur l'au moins un élément de renforcement (21,22,23,24).

3. Carte de circuit imprimé selon l'une des revendications précédentes, **caractérisée par le fait qu'**au moins un élément de renforcement (22,24) est disposé sur la face interne (13) de l'élément flexible (10).

4. Carte de circuit imprimé selon l'une quelconque des revendications 1 à 3, **caractérisée par le fait qu'**au moins un élément de renforcement (21,23) est disposé sur la face externe de l'élément flexible (10).

5. Carte de circuit imprimé selon l'une des revendications précédentes, **caractérisée en ce qu'**elle comporte un deuxième élément de renforcement (24), chacun des éléments de renforcement (22, 24) s'étendant de part et d'autre de la courbure et les éléments de renforcement (22, 24) étant disposés de sorte à laisser entre eux la partie libre (11) pour l'élément flexible (10) pour être courbée selon ladite courbure.

6. Carte de circuit imprimé selon la revendication 5, **caractérisée par le fait qu'**elle comporte au moins deux éléments raidisseurs (31, 32), disposés de part et d'autre de sa partie libre et fixés chacun sur l'élément flexible (10) ou respectivement sur un des éléments de renforcement (22, 24).

7. Carte de circuit imprimé selon la revendication 5 ou 6, **caractérisée par le fait qu'**elle comporte quatre éléments de renforcement (21,22,23,24), disposés en vis-à-vis de part et d'autre de l'élément flexible (10).

8. Carte de circuit imprimé selon l'une des revendications précédentes, **caractérisée par le fait que** l'élément flexible (10) comporte du polyimide.

9. Carte de circuit imprimé selon l'une des revendications précédentes, **caractérisée par le fait que** l'élément flexible (10) a une épaisseur d'environ 110 micromètres.

10. Carte de circuit imprimé selon l'une des revendications précédentes, **caractérisée par le fait que** les éléments de renforcement (21-24) comportent du polyamide.

11. Carte de circuit imprimé selon l'une des revendications précédentes, **caractérisée par le fait que** les éléments de renforcement (21-24) ont une épaisseur d'environ 100 à 600 micromètres

12. Module lumineux pour dispositif d'éclairage et/ou de signalisation notamment pour véhicule automobile, **caractérisé par le fait qu'**il comporte une carte de circuit imprimé selon l'une des revendications 6 à 11, les éléments raidisseurs (31, 32) étant en outre fixés à un composant du module.

13. Module selon la revendication précédente, **caractérisé par le fait que** l'un des éléments raidisseurs (31) est fixé à un composant fixe du module et l'autre des éléments raidisseurs (32), à un composant mobile du module.

14. Module selon la revendication 12, **caractérisé par le fait que** l'un des éléments raidisseurs (31) est fixé à un premier composant du module et l'autre des éléments raidisseurs (32) est fixé à un deuxième composant du module, les deux composants du module étant prévus pour être en mouvement l'un par rapport à l'autre.

## Patentansprüche

1. Flexible Leiterplatte, die ausgelegt ist, elektronische Komponenten aufzunehmen, die ein elektrisch isolierendes flexibles Element (10) aufweist, das ausgelegt ist, Leiterbahnen zur Verbindung der Komponenten zu tragen, wobei das flexible Element ferner ausgelegt ist, gemäß einer Krümmung (11) gekrümmt zu sein,
wobei die Platte ferner mindestens ein elektrisch isolierendes Verstärkungselement (21, 22, 23, 24) aufweist, das mit dem flexiblen Element (10) mechanisch fest verbunden ist, das sich auf einer Seite der Krümmung erstreckt und zwei Abschnitte aufweist:
- einen ersten Abschnitt (220), der im Wesentlichen plan ist,
- einen zweiten Abschnitt (221), der eine vorgegebene Krümmung aufweist, der auf der Seite der Krümmung (11) des flexiblen Elements (10) angeordnet ist,
**dadurch gekennzeichnet, dass** das mindestens eine Verstärkungselement (21, 22, 23, 24) angeordnet ist, einen freien Abschnitt (11) für das flexible Element (10) zu lassen, um gemäß der Krümmung gekrümmt zu sein.

2. Leiterplatte nach Anspruch 1, **dadurch gekennzeichnet, dass** sie ferner mindestens ein Versteifungselement (31) aufweist, das auf derselben Seite ihres freien Abschnitts wie das mindestens eine Verstärkungselement (21, 22, 23, 24) angeordnet ist und an dem flexiblen Element (10) oder an dem mindestens einen Verstärkungselement (21, 22, 23, 24) befestigt ist.

3. Leiterplatte nach einem der vorhergehenden Ansprüche, **dadurch gekennzeichnet, dass** mindestens ein Verstärkungselement (22, 24) an der Innenseite (13) des flexiblen Elements (10) angeordnet ist.

4. Leiterplatte nach einem der Ansprüche 1 bis 3, **dadurch gekennzeichnet, dass** mindestens ein Verstärkungselement (21, 23) an der Außenseite des flexiblen Elements (10) angeordnet ist.

5. Leiterplatte nach einem der vorhergehenden Ansprüche, **dadurch gekennzeichnet, dass** sie ein zweites Verstärkungselement (24) aufweist, wobei sich jedes der Verstärkungselemente (22, 24) beiderseits der Krümmung erstreckt und die Verstärkungselemente (22, 24) angeordnet sind, zwischen ihnen den freien Abschnitt (11) für das flexible Element (10) zu lassen, um gemäß der Krümmung gekrümmt zu sein.

6. Leiterplatte nach Anspruch 5, **dadurch gekennzeichnet, dass** sie mindestens zwei Versteifungselemente (31, 32) aufweist, die beiderseits ihres freien Abschnitts angeordnet sind und jeweils an dem flexiblen Element (10) bzw. an einem der Verstärkungselemente (22, 24) befestigt sind.

7. Leiterplatte nach Anspruch 5 oder 6, **dadurch gekennzeichnet, dass** sie vier Verstärkungselemente (21, 22, 23, 24) aufweist, die beiderseits des flexiblen Elements (10) gegenüberliegend angeordnet sind.

8. Leiterplatte nach einem der vorhergehenden Ansprüche, **dadurch gekennzeichnet, dass** das flexible Element (10) Polyimid aufweist.

9. Leiterplatte nach einem der vorhergehenden Ansprüche, **dadurch gekennzeichnet, dass** das flexible Element (10) eine Dicke von ungefähr 110 Mikrometern aufweist.

10. Leiterplatte nach einem der vorhergehenden Ansprüche, **dadurch gekennzeichnet, dass** die Verstärkungselemente (21 bis 24) Polyamid aufweisen.

11. Leiterplatte nach einem der vorhergehenden Ansprüche, **dadurch gekennzeichnet, dass** die Verstärkungselemente (21 bis 24) eine Dicke von ungefähr 100 bis 600 Mikrometern aufweisen.

12. Lichtmodul für eine Beleuchtungs- und/oder Signalisierungsvorrichtung, insbesondere für ein Kraftfahrzeug, **dadurch gekennzeichnet, dass** es eine Leiterplatte nach einem der Ansprüche 6 bis 11 aufweist, wobei die Versteifungselemente (31, 32) ferner an einer Komponente des Moduls befestigt sind.

13. Modul nach dem vorhergehenden Anspruch, **dadurch gekennzeichnet, dass** eins der Versteifungselemente (31) an einer festen Komponente des Moduls und das andere der Versteifungselemente (32) an einer beweglichen Komponente des Moduls befestigt ist.

14. Modul nach Anspruch 12, **dadurch gekennzeichnet, dass** eins der Versteifungselemente (31) an einer ersten Komponente des Moduls und das andere der Versteifungselemente (32) an einer zweiten Komponente des Moduls befestigt ist, wobei die zwei Komponenten des Moduls vorgesehen sind, um bezogen aufeinander in Bewegung zu sein.

## Claims

1. Flexible printed circuit board, configured to receive electronic components, comprising an electrically insulating flexible element (10), configured to bear conductive component-connecting tracks, the flexible element being further configured to be bent according to a curvature (11),
the board further comprising at least one electrically insulating reinforcing element (21, 22, 23, 24), mechanically secured to the flexible element (10), extending on one side of the curvature, and comprising two parts:
- a first part (220) being substantially planar,
- a second part (221) exhibiting a predefined curvature, arranged on the side of the curvature (11) of the flexible element (10),
**characterized by** the at least one reinforcing element (21, 22, 23, 24) being arranged so as to leave a free part (11) for the flexible element (10) to be bent according to said curvature.

2. Printed circuit board according to Claim 1, **characterized in that** it further comprises at least one stiffening element (31), arranged on the same side of its free part as the at least one reinforcing element (21, 22, 23, 24) and fixed to the flexible element (10) or to the at least one reinforcing element (21, 22, 23, 24) .

3. Printed circuit board according to either of the preceding claims, **characterized in that** at least one reinforcing element (22, 24) is arranged on the inner face (13) of the flexible element (10).

4. Printed circuit board according to any one of Claims 1 to 3, **characterized in that** at least one reinforcing element (21, 23) is arranged on the outer face of the flexible element (10).

5. Printed circuit board according to one of the preceding claims, **characterized in that** it comprises a second reinforcing element (24), each of the reinforcing elements (22, 24) extending on either side of the curvature and the reinforcing elements (22, 24) being arranged so as to leave between them the free part (11) for the flexible element (10) to be bent according to said curvature.

6. Printed circuit board according to Claim 5, **characterized in that** it comprises at least two stiffening elements (31, 32), arranged on either side of its free part and each fixed to the flexible element (10) or respectively to one of the reinforcing elements (22, 24).

7. Printed circuit board according to Claim 5 or 6, **characterized in that** it comprises four reinforcing elements (21, 22, 23, 24), arranged facing on either side of the flexible element (10).

8. Printed circuit board according to one of the preceding claims, **characterized in that** the flexible element (10) comprises polyimide.

9. Printed circuit board according to one of the preceding claims, **characterized in that** the flexible element (10) has a thickness of approximately 110 micrometres.

10. Printed circuit board according to one of the preceding claims, **characterized in that** the reinforcing elements (21-24) comprise polyamide.

11. Printed circuit board according to one of the preceding claims, **characterized in that** the reinforcing elements (21-24) have a thickness of approximately 100 to 600 micrometres.

12. Light module for a lighting and/or signaling device notably for a motor vehicle, **characterized in that** it comprises a printed circuit board according to one of Claims 6 to 11, the stiffening elements (31, 32) being also fixed to a component of the module.

13. Module according to the preceding claim, **characterized in that** one of the stiffening elements (31) is fixed to a fixed component of the module and the other of the stiffening elements (32) is fixed to a mobile component of the module.

14. Module according to Claim 12, **characterized in that** one of the stiffening elements (31) is fixed to a first component of the module and the other of the stiffening elements (32) is fixed to a second component of the module, the two components of the module being provided to be in motion relative to one another.
